Europäisches Patentamt

European Patent Office

Office européen des brevets

(11) Publication number: **0 388 022**
**A2**

# EUROPEAN PATENT APPLICATION

(21) Application number: **90301672.3**

(22) Date of filing: **15.02.90**

(51) Int. Cl.⁵: **H04M 3/18**

(30) Priority: **15.03.89 CA 593846**

(43) Date of publication of application:
**19.09.90 Bulletin 90/38**

(84) Designated Contracting States:
**DE FR GB NL SE**

(71) Applicant: **NORTHERN TELECOM LIMITED**
**600 de la Gauchetiere Street West**
**Montreal Quebec H3B 4N7(CA)**

(72) Inventor: **Hung, Francis Yun-Tai**
**54 Hewitt Court**
**Kanata, Ontario, K2L 3R3(CA)**

(74) Representative: **Crawford, Andrew Birkby et al**
**A.A. THORNTON & CO. Northumberland**
**House 303-306 High Holborn**
**London WC1V 7LE(GB)**

(54) **Solid state overcurrent protection device.**

(57) A solid state overcurrent protection device for use with an external current sensing impedance comprises a semiconductor body having a first region of a first conductivity type; a second region vertically adjacent to the first region, the second region being of a second conductivity type opposite to the first conductivity type; a third region vertically adjacent to the second region, the third region being of the first conductivity type; fourth and fifth regions vertically adjacent to the third region, the fourth and fifth regions being horizontally adjacent to and interdigitated with one another, and being of the first and second conductivity types respectively; interdigitated gate and cathode contacts to the fourth and fifth regions respectively, the cathode contact also being locally connected to a portion of the fourth region; and an anode contact to the first region. The semiconductor body may also have sixth and seventh regions vertically adjacent to the first region, the sixth and seventh regions being horizontally adjacent to one another and being of the first and second conductivity types respectively; and the anode contact to the first region may be made through the sixth region, the anode contact also being connected to the seventh region. The overcurrent protection device is particularly useful for protection of line interfaces in telecommunications switching equipment.

FIG. I

# SOLID STATE OVERCURRENT PROTECTION DEVICE

## Field of the Invention

This invention relates generally to solid state overcurrent protection devices, and more particularly to solid state overcurrent protection devices which are programmable by means of an external current sensing resistor and which are self-resetting when an overcurrent condition is removed.

## Background of the Invention

Overcurrent and overvoltage protection devices are used in telecommunications switching equipment to protect the switching equipment from overcurrent and overvoltage conditions on transmission lines which connect the switching equipment to subscriber communications terminals. Such overcurrent or overvoltage conditions may be induced by lightning strikes or by accidental contact of the telecommunications transmission lines with power transmission lines.

The protection devices must act rapidly under specified overcurrent or overvoltage conditions to divert the overcurrent or overvoltage from the protected switching equipment, and must reset rapidly when the overcurrent or overvoltage is removed to permit the protected switching equipment to return to normal operation.

Conventionally, primary and secondary protection devices are used to protect telecommunications switching equipment. The primary protection devices, which may be gas tubes, carbon block protectors or newer solid state devices, are connected at the outside plant cable side of a Main Distribution Frame (MDF) and act to limit the current and voltage applied to the switching equipment to values which can be handled by the secondary protection devices. The secondary protection devices, which are generally solid state devices internal to the switching equipment, act to further limit the current and voltage applied to the switching equipment to values which will not damage the switching equipment.

Conventional solid state secondary protection devices include Zener diode devices (e.g. Transorbs), varistor devices, and thyristor devices (e.g. SIDACs). Thyristor devices clamp incident surges at lower voltage levels and have lower dynamic impedances than similarly rated Zener diode and varistor devices. Consequently thyristor devices dissipate less power and can be more compact than similarly rated Zener diode and varistor devices.

U.S. Patent 4,760,439 issued July 26, 1988 in the name of J. Borkowicz, U.S. Patent 3,928,093 issued December 23, 1975 in the names of van Tongerloo et al, and U.S. Patent 3,476,993 issued November 4, 1969 in the names of Aldrich et al, disclose two terminal thyristors used as overvoltage protection devices. Chen et al, IEEE Journal of Solid State Circuits, Vol. SC-21, No. 6, pages 947 - 955, December 1986, U.S. Patent 4,511,913 issued April 16, 1985 in the name of Nagano, and Japanese Patent Document 59-98554 published June 6, 1984 in the name of Katsuhiko disclose three terminal thyristors used as overvoltage protection devices.

## Summary of the Invention

One aspect of this invention provides a solid state overcurrent protection device which is programmable by means of an external current sensing resistor and which is self-resetting when an overcurrent condition is removed.

The solid state overcurrent protection device comprises a semiconductor body having a first region of a first conductivity type and a second region vertically adjacent to the first region, the second region being of a second conductivity type opposite to the first conductivity type. The semiconductor body also has a third region vertically adjacent to the second region, the third region being of the first conductivity type, and fourth and fifth regions vertically adjacent to the third region. The fourth and fifth regions are horizontally adjacent to and interdigitated with one another, and are of the first and second conductivity types respectively. The device further comprises interdigitated gate and cathode contacts to the fourth and fifth regions respectively, and an anode contact to the first region. The cathode contact is also locally connected to a portion of the fourth region.

Thus, the protection device according to the invention is a three terminal thyristor having an interdigitated cathode and gate. The interdigitation of the cathode and gate effectively lowers the gate series resistance. The low gate series impedance permits use of the overcurrent protection device in conjunction with an external current sensing resistor which effectively sets the threshold current at which the overcurrent protection device operates to divert current from protected equipment and the holding current below which the overcurrent protection device returns to a high impedance state. Consequently, a single overcurrent protection device can be used with different external current sensing resistors to meet a range of overcurrent protection requirements, thereby providing economies of scale. Since at least one protection device is needed for each subscriber line appearance at a telecommunications switch, and modern telecommunication switches can serve tens of thousands of line appearances, such economies of scale can be significant to the overall cost of the telecommunications switch. This overcurrent protection device may also be applicable to other non-telecommunications applications, particularly in view of the adjustability of its operating characteristics by selection of an appropriate external resistance. The overcurrent protection device can be made effective for protection against overvoltages as well as overcurrents by appropriate design. The avalanche breakdown voltage of the junction defined by the second and third regions is largely determined by the doping concentration of the second region. The avalanche breakdown current can supply a trigger current to trigger the thyristor action of the overcurrent protection device. Thus, by appropriate doping of the second region, the overcurrent protection device can also be made to trigger at a specified overvoltage.

Two overcurrent protection devices connected in antiparallel can be integrated in a common semiconductor body to provide a bidirectional overcurrent protection device. In a particularly simple integration of two antiparallel devices, the semiconductor body further comprises sixth and seventh regions vertically adjacent to the first region, the sixth and seventh regions being horizontally adjacent to one another and being of the first and second conductivity types respectively, and the anode contact to the first region is made through the sixth region, the anode contact also being connected to the seventh region. Preferably, the seventh region is vertically aligned with the portion of the fourth region which is locally connected to the cathode contact.

The bidirectional device can be made effective for protection against overvoltages as well as overcurrents by appropriate doping of the second region. The avalanche breakdown voltages of the junctions defined by the first, second and third regions are largely determined by the doping concentration of the second region. The avalanche breakdown current can supply a trigger current to trigger the thyristor action of the overcurrent protection device. Thus, by appropriate doping of the second region, the overcurrent protection device can also be made to trigger at a specified overvoltages. Preferably, both junctions have substantially equal avalanche breakdown voltages.

Two pairs of such antiparallel overcurrent protection devices can be arranged side by side in a common semiconductor body to provide an overcurrent protection module which is adapted for use at a two-wire telecommunications transmission interface.

Another aspect of the invention provides an overcurrent protection circuit comprising an overcurrent protection device as defined above, and a current sensing resistor connected between the gate contact and the cathode contact of the overcurrent protection device.

Yet another aspect of the invention provides an overcurrent protection circuit for protecting tip and ring lines of telecommunications switching equipment. The overcurrent protection circuit comprises two overcurrent protection devices as defined above. One overcurrent protection device has a cathode contact for connection to a tip line of a transmission line, a gate contact for connection to a tip line of the telecommunications switching equipment, and an anode contact for connection to ground. The other overcurrent protection device has a cathode contact for connection to a ring line of the transmission line, a gate contact for connection to a ring line of the telecommunications switching equipment, and an anode contact for connection to ground. The protection circuit further comprises two current sensing resistors, each connected between the cathode contact and the gate contact of a respective one of the overcurrent protectors.

This overcurrent protection circuit is preferred over overvoltage protection circuits for protecting tip and ring lines of telecommunications switching equipment because overcurrent conditions generally develop earlier than overvoltage conditions on telecommunications transmission lines. For example, if the incoming surge increases at 100 volts per microsecond to 1 kilovolt and the protected system has an impedance of 100 ohms to ground, a maximum operating current of 100 milliamps and a maximum operating voltage of 200 volts, then the maximum operating current will be exceeded after 0.1 microsecond, whereas the maximum operating voltage will not be exceeded until after 2 microseconds. Consequently, the overcurrent protection circuit will generally trigger earlier than an overvoltage protection circuit would, thereby reducing the energy or stress applied to the protected switching equipment before the protection circuit is triggered.

Moreover, this overcurrent protection circuit is independent of the power supply voltage and can therefore be used to protect switching equipment having more than one power supply voltage.

Unlike overvoltage protection circuits, this overcurrent protection circuit need not be switched out of the circuit during the application of ringing to the transmission line. Indeed, because this overcurrent protection circuit can be left in the circuit during ringing, it will protect the ringing generator from surge currents during ringing. Hence, use of this overcurrent protection circuit avoids the need for the separate ringing generator protectors which are required in cases where overvoltage protection circuits are switched out of the circuit during the application of ringing.

Brief Description of the Drawings

Embodiments of the invention are described below by way of example only with reference to the accompanying drawings, in which:

Figure 1 is a schematic diagram of an overcurrent protection circuit employing an overcurrent protection module according to an embodiment;

Figure 2 is a plan view of the overcurrent protection module shown schematically in Figure 1;

Figure 3 is a fragmentary plan view the overcurrent protection module of Figures 1 and 2 showing a part of Figure 2 drawn to a larger scale;

Figure 4 is a fragmentary cross-sectional view of the protection module of Figures 1 and 2 taken on section line IV-IV in Figure 3; and

Figure 5 is a schematic diagram of a circuit which is roughly equivalent to the protection module of Figure 1.

Detailed Description of Embodiments

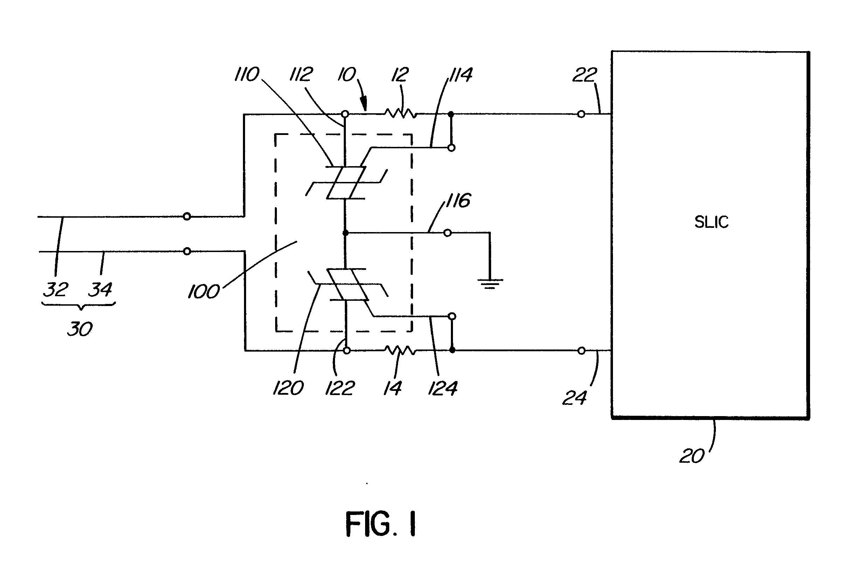

Figure 1 is a schematic diagram of an overcurrent protection circuit 10 for protecting tip and ring lines 22, 24 of a Subscriber Loop Interface Card (SLIC) 20 installed in a telecommunications switch. The protection circuit 10 is connected between the tip and ring lines 22, 24 of the SLIC 20 and corresponding tip and ring lines 32, 34 of a telecommunications transmission line 30.

The protection circuit 10 comprises an overcurrent protection module 100 which comprises two overcurrent protection devices 110, 120 connected in series between the tip and ring lines 32, 34 of the transmission line 30. One protection device 110 has a cathode contact 112 connected to the tip line 32 of the transmission line 30, a gate contact 114 connected to the tip line 22 of the SLIC 20 and an anode contact 116 connected to ground. The other protection device 120 has a cathode contact 122 connected to the ring line 34 of the transmission line 30, a gate contact 124 connected to the ring line 34 of the SLIC 20 and shares the grounded anode contact 116 with the protection device 110. The protection circuit 100 further comprises two current sensing resistors 12, 14. One current sensing resistor 12 is connected between the cathode contact 112 and the gate contact 114 of one protection device 110, and the other current sensing resistor 14 is connected between the cathode contact 122 and the gate contact 124 of the other protection device 120.

Overcurrent or overvoltage conditions may be induced on the tip or ring lines 32, 34 of the transmission line 30 by lightning strikes or by accidental contact of the transmission line 30 with a power transmission line. An overcurrent condition on the tip line 32 of the transmission line 30 will generate a significant voltage differential between the cathode contact 112 and the gate contact 114 of the protection device 110 which is connected to the tip line 32. The protection device 110 is constructed such that a voltage differential corresponding to an overcurrent condition will trigger the protection device 110, shunting the overcurrent through the protection device 110 to ground, thereby protecting the tip line 22 of the SLIC 20. An overvoltage condition on the tip line 32 of the transmission line 30 will generate a significant voltage differential between the cathode contact 112 and the anode contact 116 of the protection device 110. The protection device 110 is constructed such that an overvoltage condition will also trigger the protection device 110, shorting the overvoltage through the protection device 110 to ground, thereby protecting the tip line 22 of the SLIC 20. The other protection device 120 is similarly constructed to protect the ring line 24 of the SLIC 20 from overcurrent and overvoltage conditions on the ring line 32 of the transmission line 30.

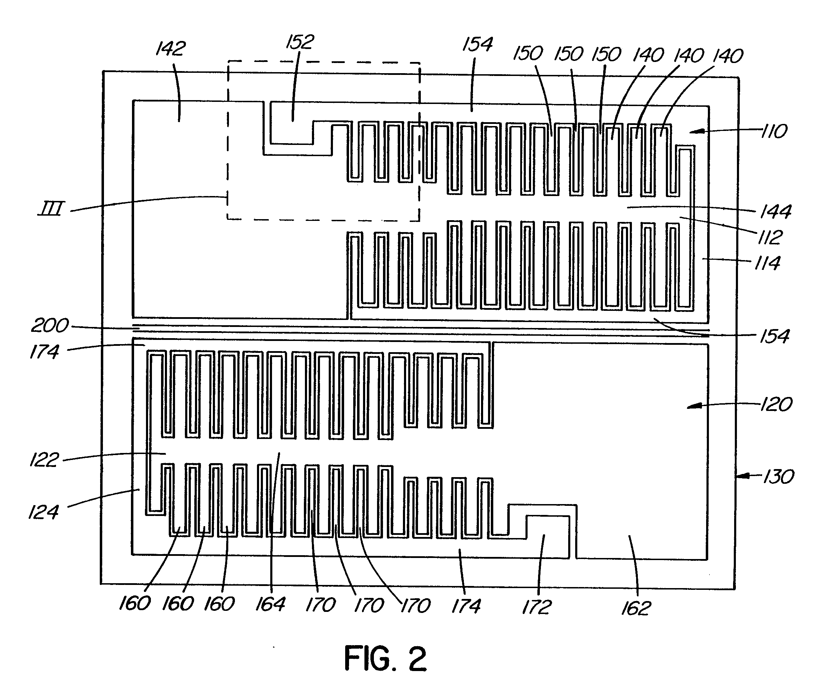

The overcurrent protection module 100 comprises a silicon body 130 shown in plan view in Figure 2. The protection devices 110, 120 are arranged side by side in the silicon body 130. The cathode contact 112 of one protection device 110 comprises thirty parallel fingers 140 arranged in two parallel rows, each finger 140 having a length to width aspect ratio of approximately ten to one. The fingers 140 are connected to a bonding pad 142 by a spine 144. The gate contact 114 of the same protection device 110 also comprises thirty parallel fingers 150 arranged in two parallel rows, each finger 150 having a length to width aspect ratio of approximately ten to one. The fingers 150 of the gate contact 114 are interdigitated with the fingers 140 of the cathode contact 112 and are connected to a bonding pad 152 by a pair of parallel spines 154.

Similarly, the cathode contact 122 of the other protection device 120 comprises thirty parallel fingers 160 arranged in two parallel rows, each finger 160 having a length to width aspect ratio of approximately ten to one. The fingers 160 are connected to a bonding pad 162 by a spine 164. The gate contact 124 of the other protection device 120 also comprises thirty parallel fingers 170 arranged in two parallel rows, each finger 170 having a length to width aspect ratio of approximately ten to one. The fingers 170 of the gate contact 124 are interdigitated with the fingers 160 of the cathode contact 122 and are connected to a bonding pad 172 by a pair of parallel spines 174.

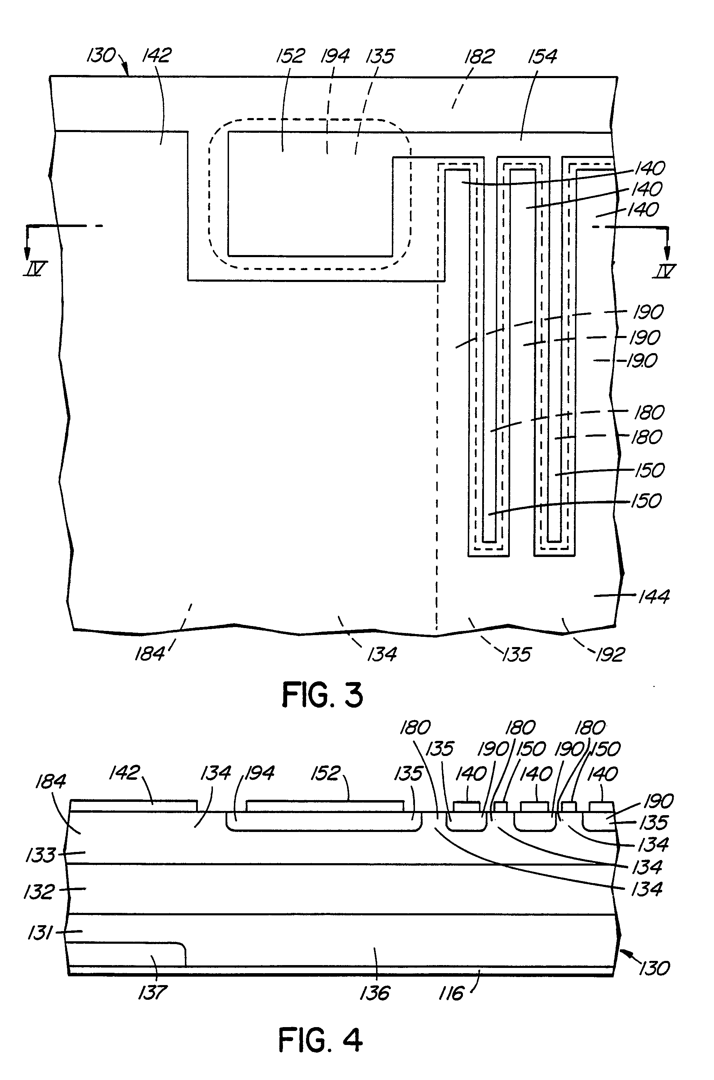

Figure 3 shows in a larger scale the region of Figure 2 which is enclosed in a rectangle drawn in dotted outline and labelled III. Figure 4 is a cross-sectional view of the silicon body 130 taken along section line IV-IV in Figure 3.

As shown in Figure 4, the silicon body 130 has a first region 131 which is doped with p-type impurities. A second region 132 is vertically adjacent to the first region 131 and is doped with n-type impurities. A third region 133 is vertically adjacent to the second region 132 and is doped with p-type impurities. Fourth and fifth regions 134, 135 are vertically adjacent to the third region 133 and are doped with p-type and n-type impurities respectively. The fourth region 134 comprises thirty fingers 180 which underlie the fingers 150 of the gate contact 114, a pair of spines 182 which underlie the spines 154 of the gate contact 114 and a rectangular portion 184 which underlies the bonding pad 142 of the cathode contact 112. The fifth region 135 comprises thirty fingers 190 which underlie the fingers 140 of the cathode contact 112, a spine 192 which underlies the spine 144 of the cathode contact 112, and a rectangular portion 194 which underlies the bonding pad 152 of the cathode contact 112. Thus, the fourth and fifth regions 134, 135 are horizontally adjacent to and interdigitated with one another, and the cathode contact 112 is locally connected to a portion 184 of the fourth region 134.

The silicon body 130 further comprises sixth and seventh regions 136, 137 which are vertically adjacent to the first region 131 and are doped with p-type and n-type impurities respectively. The sixth and seventh regions 136, 137 are horizontally adjacent to one another, and the seventh region 137 is vertically aligned with a portion of the fourth region 134 which underlies the bonding pad 142 of the cathode contact 112.

The anode contact 116 extends across the sixth and seventh regions 136, 137 and makes ohmic contact to the first region 131 via the sixth region 136 which is of the same conductivity type.

The regions 131-137 together with the cathode, gate and anode contacts 112, 114, 116 define one protection device 110 of the protection module 100. Similarly configured and doped regions together with other cathode and gate contacts 122, 124 and the same common anode contact 116 define the other protection device 120 of the protection module 100.

The regions 131-137 may be formed by well known silicon device processing techniques. For example, the first, second and third regions 131, 132, 133 may be formed by performing a p-type diffusion having a surface concentration of $10^{17}$ $cm^{-3}$ and a depth of 22 micrometers into each surface of an n-type silicon wafer having a resistivity of 4 ohm-cm and a thickness between 0.007 inches and 0.009 inches. The fourth, fifth, sixth and seventh regions 134, 135, 136, 137 may then be formed by performing an n-type diffusion having a surface concentration of $10^{19}$ $cm^{-3}$ and a depth of 7 micrometers into the silicon wafer where fifth and seventh regions 135, 137 are desired. A p-type base enhancement diffusion having a surface concentration of $10^{19}$ $cm^{-3}$ and a depth of 0.5 micrometers may then be performed. As these and equivalent silicon processing techniques are well known, they will not be described in greater detail here.

The gate contacts 114, 124 of the protection devices 110, 120 are electrically isolated from one another by an isolation trench or a p-type isolation diffusion which extends through the third and fourth regions 133, 134 between the contacts 114, 124 as shown at reference numeral 200 in Figure 2.

The protection module is enclosed in a package using well known packaging techniques commonly used for silicon power devices.

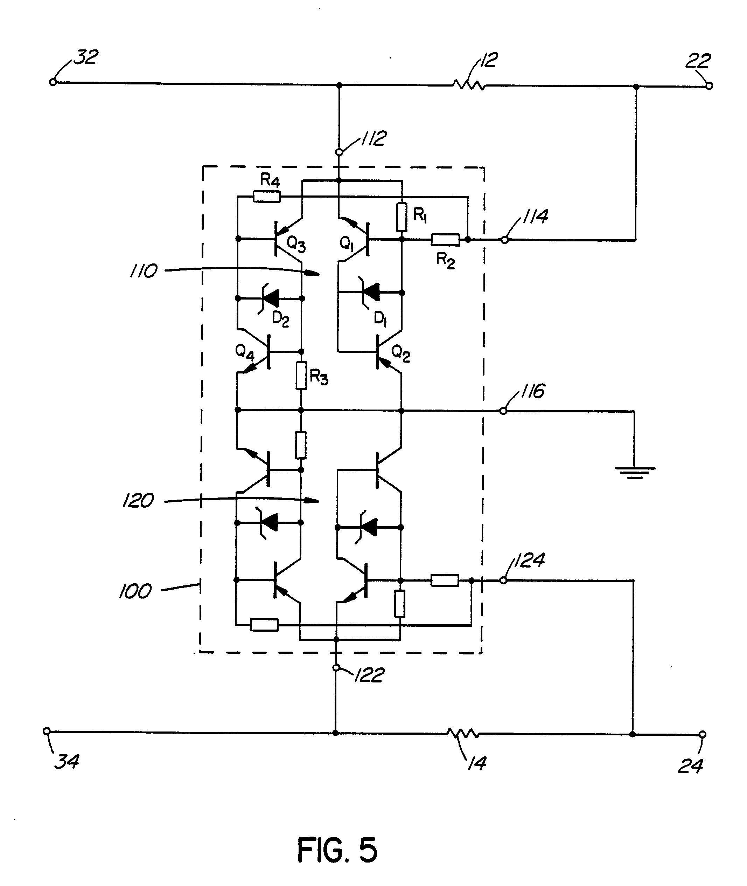

A schematic diagram of an approximate equivalent circuit for the protection module 100 is shown in Figure 5. Q1 represents an npn transistor comprising the fifth n-type region 135, the third and fourth p-type regions 133, 134 and the second n-type region 132. Q2 represents a pnp transistor comprising the first p-type region 131, the second n-type region 132 and the third p-type region 133. D1 represents a junction comprising the second n-type region and the third p-type region 133. R1 represents a shunt impedance between the cathode contact 112 and the gate contact 114 via the third and fourth p-type regions 133, 134. Shunt impedance R1 is present because the cathode contact 112 is connected to the p-type fourth region 134 as well as the n-type fifth region 135. R2 represents a parasitic series impedance at the gate of transistor Q1. R2 is made small by interdigitation of the cathode and gate contacts 112, 114 and by interdigitation of the fourth and fifth p-type and n-type regions 134, 135 which underlie the interdigitated contacts 112, 114.

If the tip line 32 of the transmission line 30 draws a current from the tip line 22 of the SLIC 20, a voltage is generated across the current sensing resistor 12. Because the parasitic series resistance R2 is much smaller than the shunt resistance R1, the voltage appearing across the external current sensing resistor 12 appears substantially across the base-emitter junction of Q1. The value of the current sensing resistor 12 is selected to ensure that an overcurrent will generate a voltage across the current sensing resistor 12 which is sufficient to turn on transistor Q1. Transistor Q1 turns on transistor Q2, and the overcurrent is supplied to the tip line 32 of the transmission line 30 from ground by the protection device 110, thereby protecting the tip line 22 of the SLIC 20.

The value of the current sensing resistor 12 is selected to ensure that normal operating currents of the transmission line 30 and SLIC 20 will not trigger the protection device 110, but currents dangerous to the SLIC 20 will trigger the protection device 110. Because the values of these currents may depend on the particular design of the SLIC 20, it is advantageous to make the current sensing resistor 12 external to the protection module 100 so that the same protection module 100 can be programmed by selection of the resistor 12 for different applications, thereby realizing economies of scale.

When the overcurrent condition is no longer present on the tip line 32 of the transmission line 30, the protection device 110 must reset to permit normal operation of the SLIC 20. The protection device 110 will reset when the current passing through the external current sensing resistor 12 is too small to generate a voltage across the base-emitter junction of transistor Q1 which is adequate to turn the transistor Q1 on, and the current passing through the base-emitter junction of the transistor Q1 is too small to sustain thyristor operation.

When the overcurrent condition subsides, the current passing through the current sensing resistor 12 reverses direction and is therefore of the wrong polarity to turn on the transistor Q1. However, transistors Q1 and Q2 would remain on if the tip line of the SLIC 20 could draw enough current through the base-emitter junction of the transistor Q1 to sustain thyristor operation. The shunt impedance R1 and the parasitic series resistance R2 each divert some current from the base-emitter junction of transistor Ql. The parasitic series impedance R2 is much smaller than the shunt impedance R1 due to the interdigitation of the cathode and gate contacts 112, 114 and the interdigitation of the fourth and fifth p-type and n-type regions 134, 135 which underlie the interdigitated contacts 112, 114. The external current sensing resistor 12 is also smaller than the shunt impedance R1. Consequently, most of the diverted current passes through the parasitic series impedance R2 and the external current sensing resistor 12.

The current into the tip line 22 of the SLIC 20 is the sum of the diverted current and the current passing through the base-emitter junction of transistor Q1 in series with the external current sensing resistor 12. Thus, the current into the tip line 22 of the SLIC 20 which is required to hold the protection device 110 in its low impedance state is significantly greater than current which must pass through the base-emitter junction of the transistor Q1 to hold the protection device 110 in its low impedance state. Moreover, the current into the tip line 22 of the SLIC 20 which is required to hold the protection device 110 in its low impedance state is largely determined by the value of the external current sensing resistor 12 and can therefore be adjusted by appropriate selection of the current sensing resistor. The current sensing resistor is selected to ensure that the current into the tip line 22 of the SLIC 20 which is required to hold the protection device 110 in its low impedance state exceeds the normal operating current of the SLIC 20.

If the voltage on the tip line 32 of the transmission line 30 drops sufficiently low, junction D1 goes into reverse avalanche breakdown to provide sufficient current to turn on transistors Q1 and Q2. The doping of the second region 132 is selected to set the reverse breakdown voltage of the junction D1 at a voltage which is greater in magnitude than normal operating voltages of the tip lines 22, 32 of the SLIC 20 and transmission line 30 but smaller in magnitude than overvoltages which could damage the SLIC 20 and other components in the circuit, such as solid state relays. Thus, the protection device 110 operates to protect the SLIC 20 and other components from overvoltages as well as overcurrents, while permitting normal operation of the SLIC 20.

Q3 represents a pnp transistor comprising the first p-type region 131, the second n-type region 132, and the third and fourth p-type regions 133, 134. Q4 represents an npn transistor comprising the seventh n-type region 137, the first p-type region 131 and the second n-type region 132. D2 represents a junction comprising the first p-type region 131 and the second n-type region 132. R3 represents a shunt impedance between sixth p-type region 136 and the seventh n-type region 137 via the anode contact 116 which is connected to both of these regions. R4 represents a parasitic series impedance at the gate of transistor Q3.

If the tip line 32 of the transmission line 30 supplies an overcurrent from the tip line 22 of the SLIC 20, a sufficient voltage is generated across the current sensing resistor 12 to turn on transistor Q3. Q3 turns on Q4, and the overcurrent is drawn from the tip line 32 of the transmission line 30 to ground by the protection device 110, thereby protecting the tip line 22 of the SLIC 20. As noted above, the value of the current sensing of the SLIC 12 is selected to ensure that normal operating currents of the transmission line 30 and SLIC 20 will not trigger the protection device 110, but currents dangerous to the SLIC 20 will trigger the protection device 110.

When the overcurrent condition is no longer present on the tip line 32 of the transmission line 30, the protection device 110 must reset to permit normal operation of the SLIC 20. The protection device 110 will reset when the current passing through the external current sensing resistor 12 is too small to generate a voltage across the base-emitter junction of transistor Q3 which is adequate to turn the transistor Q3 on, and the current passing through the base-emitter junction of the transistor Q3 is too small to sustain thyristor operation.

When the overcurrent condition subsides, the current passing through the current sensing resistor 12 is too small to turn on the transistor Q1. Moreover, the tip line of the SLIC 20 is at a negative potential relative to ground, so the SLIC cannot provide the current across the base-emitter junction of the transistor Q3 which would be required to sustain thyristor action.

If the voltage on the tip line 32 of the transmission line 30 drops sufficiently low, junction D2 goes into reverse avalanche breakdown to provide sufficient current to turn on transistors Q3 and Q4. The doping of the second region 132 is selected to set the reverse breakdown voltage of the junction D2 at a voltage which is greater in magnitude than normal operating voltages of the tip lines 22, 32 of the SLIC 20 and transmission line 30 but smaller in magnitude than overvoltages which could damage the SLIC 20. For symmetrical operation, the reverse breakdown voltage of D2 would normally be set to the substantially the same value as the reverse breakdown voltage of D1.

The operation of the protection device 120 for protection of the ring line 24 of the SLIC 20 is essentially as described above for the operation of the protection device 110 for protection of the tip line 22.

Note that the doping polarities described above are preferred for the intended application of the embodiment described above because of the polarities of the power supply voltages in that application. However, in other applications it may be desirable to use doping polarities opposite to those described above.

## Claims

1. A solid state overcurrent protection device for use with an external current sensing impedance, the protection device comprising:
a semiconductor body having:
a first region of a first conductivity type;
a second region vertically adjacent to the first region, the second region being of a second conductivity type opposite to the first conductivity type;
a third region vertically adjacent to the second region, the third region being of the first conductivity type;
fourth and fifth regions vertically adjacent to the third region, the fourth and fifth regions being horizontally adjacent to and interdigitated with one another, and being of the first and second conductivity types respectively;
interdigitated gate and cathode contacts to the fourth and fifth regions respectively, the cathode contact also being locally connected to a portion of the fourth region; and
an anode contact to the first region.

2. An overcurrent protection device as defined in claim 1, wherein:
the semiconductor body further comprises sixth and seventh regions vertically adjacent to the first region, the sixth and seventh regions being horizontally adjacent to one another and being of the first and second conductivity types respectively; and
the anode contact to the first region is made through the sixth region, the anode contact also being connected to the seventh region.

3. An overcurrent protection device as defined in claim 2, wherein the seventh region is vertically aligned with the portion of the fourth region which is locally connected to the cathode contact.

4. An overcurrent protection device as defined in claim 2, wherein the second and third regions together define a first junction, and the first and second regions together define a second junction, and the first and second junctions have substantially equal reverse avalanche breakdown voltages.

5. An overcurrent protection module, comprising two overcurrent protection devices as defined in claim 2 arranged side by side in a common semiconductor body.

6. An overcurrent protection module as defined in claim 5, wherein the two overcurrent protection devices share a common anode contact.

7. An overcurrent protection device as defined in claim 1, wherein the first conductivity type is p-type and the second conductivity type is n-type.

8. An overcurrent protection device as defined in claim 1, wherein the semiconductor body is a silicon body.

9. An overcurrent protection circuit, comprising:
an overcurrent protection device as defined in claim 1; and
a current sensing resistor connected between the gate contact and the cathode contact of the overcurrent protection device.

10. An overcurrent protection circuit for protecting tip and ring lines of telecommunications switching equipment, the overcurrent protection circuit comprising:
two overcurrent protection devices as defined in claim 2, one overcurrent protection device having a cathode contact for connection to a tip line of a transmission line, a gate contact for connection to a tip line of the telecommunications switching equipment, and an anode contact for connection to ground, and the other overcurrent protection device having a cathode for connection to a ring line of the transmission line, a gate contact for connection to a ring line of the telecommunications switching equipment, and an anode contact for connection to ground; and
two current sensing resistors, each connected between the cathode contact and the gate contact of a respective one of the overcurrent protectors.

FIG. 1

EP 0 388 022 A2

FIG. 2

EP 0 388 022 A2

**FIG. 3**

**FIG. 4**

FIG. 5